# EUROPÄISCHE PATENTANMELDUNG

(11) **EP 0 921 637 A2**
(43) Veröffentlichungstag der Anmeldung: **09.06.1999**
(21) Anmeldenummer: 98122728.3
(22) Anmeldetag: 28.11.1998
(51) Int. Cl.: H03J 1/00

(54) **Rundfunkempfänger mit Senderspeicheraktualisierung**

(30) Priorität: 04.12.1997 DE 19753715
(71) Anmelder: GRUNDIG Aktiengesellschaft, 90762 Fürth (DE)
(72) Erfinder: Kalmer, Mathias, Grundig AG, 90762 Fürth (DE); Hofmann, Georg, Grundig AG, 90762 Fürth (DE)

(57) **Zusammenfassung**

Die Erfindung betrifft einen Rundfunkempfänger zum Empfang und zur Wiedergabe von Rundfunksignalen. Bei diesem Empfänger erfolgt die Belegung des Senderspeichers durch einen automatischen Suchlauf nach dem ersten Einschalten des Gerätes. Im späteren Gerätebetrieb erfolgt stets dann, wenn keine Rundfunkwiedergabe vorgenommen wird, ein automatischer Hintergrundsuchlauf, um sicherzustellen, daß stets die Empfangsdaten der am besten empfangbaren Sender im Senderspeicher abgelegt sind und daß auch Sender, die den Sendebetrieb neu aufgenommen haben, im Senderspeicher repräsentiert sind.

## Beschreibung

Die Erfindung betrifft einen Rundfunkempfänger mit den im Oberbegriff des Anspruchs 1 angegebenen Merkmalen.

Es sind bereits Rundfunkempfänger bekannt, bei denen der Senderspeicher bei der ersten Inbetriebnahme des Gerätes automatisch mit den Empfangsdaten aller am momentanen Standort des Gerätes empfangbaren Rundfunksendern belegt wird, deren Empfangsqualität als ausreichend erkannt wird. Die Abspeicherung der Daten im Senderspeicher erfolgt beispielsweise in der Reihenfolge ihrer Empfangsqualität. Diese Reihenfolge kann nach erfolgter automatischer Programmierung nach den individuellen Wünschen des Benutzers geändert werden. Weiterhin ist es bereits bekannt, während des Gerätebetriebes mittels einer Suchlauftaste der Bedieneinheit manuell einen Suchlauf auszulösen, um die Empfangsdaten derjenigen Sender zusätzlich in den Senderspeicher aufzunehmen, die den Sendebetrieb neu aufgenommen haben. Dies hat jedoch den Nachteil, daß der Benutzer erst einmal von der Existenz des neuen Senders Kenntnis haben muß, um den genannten manuellen Suchlauf auszulösen.

Ausgehend von diesem Stand der Technik liegt der Erfindung die Aufgabe zugrunde, einen Weg aufzuzeigen, wie die Speicherbelegung des Senderspeichers verbessert werden kann. Diese Aufgabe wird bei einem Rundfunkempfänger mit den im Oberbegriff des Anspruchs 1 angegebenen Merkmalen durch die im kennzeichnenden Teil des Anspruchs 1 angegebenen Merkmalen gelöst. Vorteilhafte Ausgestaltungen und Weiterbildungen der Erfindung ergeben sich aus den abhängigen Ansprüchen.

Die Vorteile der Erfindung bestehen insbesondere darin, daß eine Aktualisierung des Senderspeichers automatisch erfolgt, so daß die Notwendigkeit einer diesbezüglichen benutzerseitigen Maßnahme nicht mehr gegeben ist. Weiterhin wird mittels der Erfindung erreicht, daß beim Vorliegen von Senderketten, beispielsweise "BAYERN 3", im Senderspeicher stets die Empfangsdaten desjenigen Senders der Senderkette abgespeichert sind, dessen Empfangsqualität am momentanen Empfangsort am höchsten ist.

In den Ansprüchen 2 bis 4 ist angegeben, in welchen weiteren Betriebsarten des Rundfunkempfängers der Hintergrundsuchlauf erfolgen kann. Allen diesen weiteren Betriebsarten ist gemeinsam, daß in diesen keine vom Tuner des Empfängers abgeleiteten Rundfunksignale über die Lautsprecher wiedergegeben werden.

Mittels der Merkmale des Anspruchs 5 wird sichergestellt, daß der Mikrocomputer des Rundfunkempfängers, der nicht nur den Suchlauf, sondern auch eine Vielzahl anderer Funktionen des Rundfunkempfängers steuert, durch den Hintergrundsuchlauf nicht in unnötiger Weise von der Erfüllung anderer, vorrangiger Aufgaben abgehalten wird, sondern den Hintergrundsuchlauf nur dann steuert, wenn Zeit vorhanden ist.

Die Ansprüche 7 bis 10 geben Auskunft darüber, wie der Senderspeicher eines erfindungsgemäßen Rundfunkempfängers aufgebaut ist und welche Informationen er enthält.

Der Anspruch 11 betrifft die Qualtitätsbeurteilung des Empfangssignals. Insbesondere ist der verwendete Feldstärkeschwellwert variabel, so daß er an die am Empfangsort vorliegenden Empfangsbedingungen angepaßt werden kann. Durch diese Anpassung des Feldstärkeschwellwertes an die Empfangsbedingungen kann beispielsweise erreicht werden, daß der Suchlauf weder bei zu vielen "schlechten" Sendern anhält, noch bei zu wenigen "guten" Sendern stoppt.

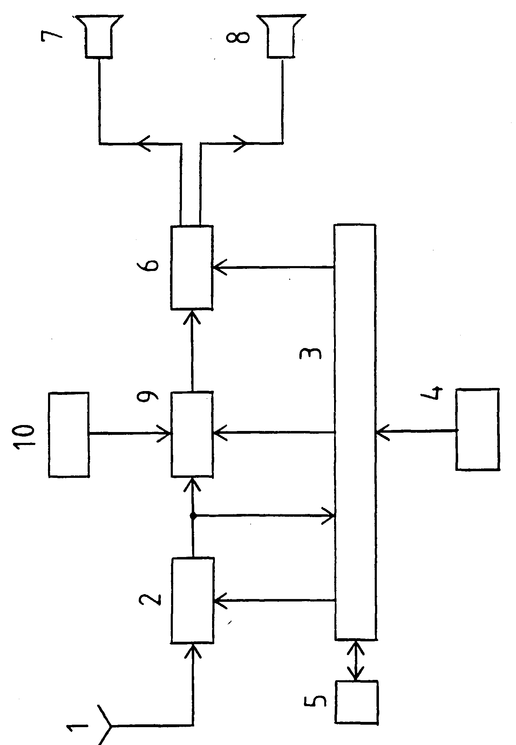

Weitere Vorteile der Erfindung ergeben sich aus der Erläuterung eines Ausführungsbeispiels anhand der Figur.

Diese zeigt die zum Verständnis der Erfindung notwendigen Bauteile eines Rundfunkempfängers, bei dem es sich vorzugsweise um ein Autoradio handelt. Diesem werden über eine Empfangsantenne 1 hochfrequente Hörrundfunksignale zugeführt und an den Tuner 2 weitergegeben. In diesem erfolgt eine Frequenzumsetzung des Signals unter Verwendung eines Umsetzsignals, welches von einem Mikrocomputer 3 geliefert wird. Dieser ermittelt das genannte Umsetzsignal in Abhängigkeit von einer mittels der Bedieneinheit 4 durchgeführten Kanalwahl und unter Verwendung von in einem Senderspeicher 5 abgespeicherten Empfangsdaten.

Die im Senderspeicher 5 abgespeicherten Empfangsdaten werden bei der ersten Inbetriebnahme des Autoradios durch einen automatischen Suchlauf ermittelt, bei welchem im gesamten Empfangsfrequenzband, beispielsweise beginnend mit der unteren Grenzfrequenz in aufsteigender Richtung bis zur oberen Grenzfrequenz, nach Rundfunkprogrammen gesucht wird, deren Empfangsqualitität ein vorgegebenes Mindestmaß übersteigt. Bei den im Senderspeicher 5 abgespeicherten Empfangsdaten handelt es sich vorzugsweise um eine Information über die Empfangsfrequenz des jeweiligen Rundfunkprogrammes, die in Form eines Teilerverhältnisses vorliegt, und um weitere Informationen über das jeweilige Rundfunkprogramm, wie unten noch erläutert wird.

Im späteren Gerätebetrieb wird in Abhängigkeit von der Kanalwahl das zugehörige Teilerverhältnis aus dem Senderspeicher 5 ausgelesen und in Form des Umsetzsignals dem Tuner 2 zugeführt.

In einer ersten Betriebsart des in der Figur gezeigten Rundfunkempfängers wird das Ausgangssignal des Tuners 2 dem Mikrocomputer 3 und über einen Umschalter 9, der vom Mikrocomputer 3 gesteuert wird, einer Signalverarbeitungsschaltung 6 zugeführt. In dieser Signalverarbeitungsschaltung 6, die ebenfalls vom Mikrocomputer 3 gesteuert wird, erfolgt eine dem Fachmann bekannte Signalverarbeitung zur Erzeugung von L- und R-Audiosignalen, die den Lautsprechern 7 und 8 zugeleitet und von diesen ausgestrahlt bzw. wiedergegeben werden.

Weiterhin ist in der Figur eine weitere Signalquelle 10 gezeigt, bei der es sich um einen CD-Spieler, einen Kassettenteil des Rundfunkempfängers oder um ein Telefon handeln kann. Der Ausgang dieser weiteren Signalquelle 10 ist ebenfalls mit dem Schalter 9 verbunden, so daß bei einer entsprechendem Umschaltung des Schalters 9 in einer weiteren Betriebsart des Rundfunkempfängers von dieser weiteren Signalquelle 10 abgeleitete Signale über die Signalverarbeitungsschaltung 6 den Lautpsrechern 7 und 8 zugeführt werden.

Der Senderspeicher 5 wurde - wie oben bereits angegeben - bei der ersten Inbetriebnahme des Autoradios durch einen automatischen Suchlauf mit den Empfangsdaten der ermittelten Rundfunkprogramme beschrieben.

Um sicherzustellen, daß auch stets die Empfangsdaten der besten aktuell empfangbaren Rundfunkprogramme im Senderspeicher 5 abgespeichert sind, ist gemäß der Erfindung vorgesehen, daß in der weiteren Betriebsart des Rundfunkempfängers von Mikrocomputer 3 ein Hintergrundsuchlauf gesteuert wird. Eine weitere Betriebsart im Sinne der Erfindung liegt stets dann vor, wenn keine Wiedergabe von Rundfunksignalen erfolgt, die vom Tuner 2 abgeleitet sind. Derartige weitere Betriebsarten im Sinne der Erfindung sind neben dem bereits beispielhaft genannten Kassettenbetrieb, dem CD-Wedergabebetrieb und dem Telefonbetrieb auch ein herkömmlicher Bereitschaftsbetrieb sowie beispielsweise ein Verkehrsfunkbereitschaftsbetrieb. Als weitere Betriebsarten kommen der Minidisc-Wiedergabebetrieb, der DAB-Betrieb, der DAT-Betrieb, der Navigationssprachausgabebetrieb, der Video-/TV-Betrieb und/oder der Multimediabetrieb in Betracht.

Ist der Rundfunkempfänger in einem Kraftfahrzeug eingebaut, dann ist er in vorteilhafter Weise derart mit der Zündanlage des Kraftfahrzeugs gekoppelt, daß der Rundfunkempfänger bei einem Einschalten der Zündung automatisch in den Bereitschaftsbetrieb gebracht wird. In einer weiteren vorteilhaften Ausgestaltung der Erfindung ist der Rundfunkempfänger mit einer Einheit des Kraftfahrzeuges verbunden, welche den Rundfunkempfänger in den Bereitschaftsbetrieb bringt, wenn ein Betriebszustand des Kraftfahrzeuges vorliegt, bei welchem ein Stomverbrauch eines Verbrauchers zulässig ist. Beispielweise wird dies über eine Transpondereinheit realisiert.

Der Verkehrsfunkbereitschaftsbetrieb ist eine besondere Art von Bereitschaftsbetrieb, bei dem zwar keine Radiowiedergabe erfolgt, der Tuner aber auf ein Verkehrsfunkdurchsagen ausstrahlendes Rundfunkprogramm abgestimmt ist und bei dem nur eintreffende Verkehrsnachrichten über die Lautsprecher wiedergegeben werden. In diesem Verkehrsfunkbereitschaftsbetrieb erfolgt der genannte Hintergrundsuchlauf periodisch, beispielsweise alle 60 Sekunden, und nur kurzzeitig, beispielsweise jeweils für die Dauer vom 500 Millisekunden, um möglichst keine Verkehrsdurchsagen zu verpassen. Der Verkehrsfunkbereitschaftsbetrieb kann derart ausgestaltet sein, daß er ständig aktiviert ist.

Der genannte Hintergrundsuchlauf beginnt beispielsweise mit der unteren Grenzfrequenz des Empfangsfrequenzbandes und wird in aufsteigender Richtung bis zur oberen Grenzfrequenz des Empfangsfrequenzbandes durchgeführt. Der zur Steuerung des Hintergrundsuchlaufes vorgesehene Mikrocomputer 3 ist ein sog. Multi-Task-Mikrocomputer, der zur Durchführung einer Vielzahl von Aufgaben vorgesehen ist. Um diesen Mikrocomputer nicht von der Durchführung anderer wichtiger Aufgaben abzuhalten, wird beim Vorliegen eines Unterbrechungssignals, mittels dessen der Mikrocomputer zur Durchführung einer anderen Aufgabe aufgefordert wird, der Hintergrundsuchlauf unterbrochen. Ist der Mikrocomputer wieder frei von anderen Aufgaben, dann wird der Hintergrundsuchlauf an der Stelle des Empfangsfrequenzbandes fortgesetzt, an der er unterbrochen wurde.

Die Empfangsqualität eines im Rahmen des Hintergrundsuchlaufes aufgefundenen Rundfunkprogramms wird im Mikrocomputer 3 anhand der Empfangsfeldstärke, des Vorliegens von Mehrwegeempfang und der Mittigkeit des Senders beurteilt. Zu diesem Zweck ist im Mikrocomputer ein Feldstärkeschwellwert abgespeichert, der zum Vergleich mit der jeweiligen Empfangsfeldstärke verwendet wird. Liegt die jeweilige Empfangsfeldstärke über diesem Feldstärkeschwellwert, dann wird das zugehörige Rundfunkprogramm als empfangswürdig angesehen und es erfolgt eine Auswertung im Hinblick auf das Vorliegen von Mehrwegeempfang und im Hinblick auf die Mittigkeit des Senders. Im nächsten Schritt erfolgt eine Zwischenspeicherung dieser Informationen über die Empfangsqualität im Mikrocomputer 3. Weiterhin werden im Mikrocomputer 3 aus den zusammen mit dem vorliegenden Rundfunkprogramm übertragenen Begleitinformationen die Senderidentifizierungsinformation und - falls vorhanden - eine Verkehrsfunkkennung, eine Programmtypkennung sowie Informationen über alternative Frequenzen abgetrennt und zwischengespeichert. Beim Vorliegen eines RDS-Senders liegen die genannten Informationen in Form des PI-Codes, des TP-Codes, des PTY-Codes und der AF-Codes vor.

Anschließend erfolgt im Mikrocomputer 3 eine Überprüfung, ob im Senderspeicher 5 bereits die Daten eines Senders mit übereinstimmender Senderidentifizierungsinformation abgespeichert sind. Ist dies der Fall, dann werden die Informationen über die Empfangsqualität des bereits abgespeicherten Senders mit den entsprechenden Informationen des neu aufgefundenen Senders verglichen.

Ergibt dieser Vergleich, daß der neu aufgefundene Sender mit besserer Empfangsqualität empfangbar ist, dann erfolgt im Senderspeicher 5 ein Überschreiben der dort abgespeicherten Empfangsdaten des jeweiligen Senders durch die entsprechenden Empfangsdaten des neu aufgefundenen Senders. Zu diesen Empfangsdaten eines Senders gehören neben der Empfangsfrequenz bzw. dem zugehörigen Teilerverhältnis auch die Empfangsfeldstärke, die Information über das Vorliegen von Mehrwegeempfang, die Information über die Mittigkeit des Senders, die Senderidentifizierungsinformation und - soweit vorhanden - die Verkehrsfunkkennung, die Programmtypkennung und Informationen über alternative Frequenzen.

Ergibt der genannte Vergleich, daß der neu aufgefundene Sender mit schlechterer Empfangsqualität empfangbar ist, dann wird der neu aufgefundene Sender ignoriert und der Hintergrundsuchlauf fortgesetzt.

Ergibt die nach dem Auffinden eines neuen empfangswürdigen Senders im Mikrocomputer 3 erfolgende Überprüfung, daß im Senderspeicher 5 kein Sender mit übereinstimmender Senderidentifizierungsinformation vorhanden ist, dann werden die Empfangsdaten dieses neu aufgefundenen Senders zusätzlich zu den bisher abgespeicherten Empfangsdaten der anderen Sender im Senderspeicher 5 abgespeichert. Weiterhin wird in diesem Fall der Benutzer durch eine Anzeige auf dem Display des Rundfunkempfängers über das Auffinden eines neuen Senders informiert.

Der Senderspeicher 5 weist einen ersten Speicherblock zur Abspeicherung der Empfangsdaten von FM-Sendern ohne RDS, einen zweiten Speicherblock zur Abspeicherung der Empfangsdaten von FM-RDS-Sendern und einen dritten Speicherblock zur Abspeicherung der Empfangsdaten von weiteren Rundfunksendern auf. Die im ersten Speicherblock des Senderspeichers 5 abgespeicherten Empfangsdaten von FM-Sendern ohne RDS sind nach aufsteigenden oder abfallenden Empfangsfrequenzen sortiert, so daß die dem Sender mit der niedrigsten Empfangsfrequenz zugehörigen Empfangsdaten am Anfang des ersten Speicherblocks stehen, usw. Die im zweiten Speicherblock des Senderspeichers 5 abgespeicherten Empfangsdaten von FM-RDS-Sendern sind nach einer vom PI-Code abhängigen Reihenfolge sortiert. Dieser PI-Code besteht jeweils aus zwei Datenbytes mit je acht Bits, wobei jedes 8-Bit-Wort zwei sog. "Nibbles" bildet. Diese insgesamt vier Nibbles, die jeweils vier Bits aufweisen, enthalten nähere Informationen über den jeweiligen Sender, beispielsweise eine Länderkennung, eine Regionalkennung, eine Information über die Senderreichweite, eine Programmnummer, usw. Diese im PI-Code enthaltenen Informationen werden zur Sortierung von RDS-Sendern im Senderspeicher 5 verwendet.

Weiterhin weisen die im Senderspeicher 5 abgespeicherten Empfangsdaten jedes Senders bzw. Rundfunkprogramms eine Prioritätsinformation auf, die von der Empfangsqualität des jeweiligen Senders abhängig ist. Sendern, die beispielsweise aufgrund eines Standortwechsels eines Kraftfahrzeugs, in welchem der Empfänger eingebaut ist, nur noch schlecht empfangbar sind, wird die niedrigste Prioritätsinformation zugeordnet. Ist der Senderspeicher 5 gefüllt und werden beim Hintergrundsuchlauf neue Sender mit hoher Empfangsqualität aufgefunden, dann werden die Empfangsdaten dieser neuen Sender mit hoher Empfangsqualität anstelle der Empfangsdaten der Sender mit schlechter Empfangsqualität im Senderspeicher 5 abgespeichert.

Gemäß einer vorteilhaften Weiterbildung der Erfindung ist der zur Beurteilung der Empfangsqualität verwendete Feldstärkeschwellwert, der vorzugsweise werksseitig vorgegeben ist, variabel. Diese Variabilität ist dadurch realisiert, daß werksseitig mehrere Feldstärkeschwellwerte vorgegeben sind, von denen einer in Abhängigkeit von den jeweils vorliegenden Empfangsbedingungen automatisch ausgewählt wird. Diese automatische Auswahl erfolgt durch eine Auswertung der Empfangsfeldstärken der empfangenen Signale. Zeigt diese Auswertung beispielsweise, daß kein einziger Sender mit hoher Empfangsfeldstärke empfangbar ist, dann deutet der auswertende Mikrocomputer 3 dies als das Vorliegen schlechter Empfangsverhältnisse und wählt einen niedrigeren Feldstärkeschwellwert zur Beurteilung der Empfangsqualität aus, um sicherzustellen, daß trotz schlechter Empfangsverhältnisse eine hinreichende Anzahl von Sendern als empfangswürdig eingestuft wird. Im Rahmen der genannten Auswertung kann auch eine Mittelung der Empfangsfeldstärken der aufgefundenen Sender durchgeführt werden, um anhand des erhaltenen Mittelwertes abschätzen zu können, ob der verwendete Feldstärkeschwellwert verändert werden muß oder nicht.

## Patentansprüche

1. Rundfunkempfänger zum Empfang und zur Wiedergabe von Rundfunksignalen, mit einem Tuner als erster Signalquelle, einem Senderspeicher, einem Mikrocomputer und einer Lautsprechereinheit, wobei in den Speicherbereichen des Senderspeichers Empfangsdaten mehrerer Rundfunkprogramme abgespeichert sind, welche Empfangsdaten jeweils Informationen über die Empfangsfrequenz und eine Senderidentifizierungsinformation enthalten, und wobei in einer ersten Betriebsart des Empfängers vom Tuner abgeleitete Signale über die Lautsprechereinheit wiedergegeben werden, wobei die abgespeicherten Empfangsdaten jedes Rundfunkprogramms weiterhin Informationen über die Empfangsqualität des jeweiligen Rundfunkprogramms enthalten, der Mikrocomputer (3) derart programmiert ist, daß er in einer weiteren Betriebsart des Empfängers einen Hintergrundsuchlauf steuert, beim Auffinden eines Rundfunkprogramms mit übereinstimmender Senderidentifizierungsinformation und besserer Empfangsqualität eine Abspeicherung der Empfangsdaten des Rundfunkprogramms besserer Empfangsqualität anstelle der abgespeicherten Empfangsdaten im Senderspeicher (5) steuert und beim Auffinden eines neuen Rundfunkprogramms, dessen Senderidentifizierungsinformation bisher im Senderspeicher (5) nicht enthalten ist, eine zusätzliche Abspeicherung der Empfangsdaten des neuen Rundfunkprogramms im Senderspeicher (5) steuert.

2. Rundfunkempfänger nach Anspruch 1,
**dadurch gekennzeichnet,**
daß eine weitere Betriebsart des Empfängers der Bereitschaftsbetrieb ist.

3. Rundfunkempfänger nach Anspruch 2,
**dadurch gekennzeichnet,**
daß er in einem Kraftfahrzeug vorgesehen ist und daß er bei einem Betriebszustand des Kraftfahrzeuges, bei welchem ein Stomverbrauch eines Verbrauchers zulässig ist, wie beispielweise beim Einschalten der Zündung des Kraftfahrzeugs, in den Bereitschaftsbetrieb gebracht wird.

4. Rundfunkempfänger nach einem der Ansprüche 1 bis 3,
**dadurch gekennzeichnet,**
daß eine weitere Betriebsart des Empfängers der Kassettenwiedergabebetrieb und/oder der CD-Wiedergabebetrieb ist und/oder der Telefonbetrieb und/oder der Minidisc-Wiedergabebetrieb und/oder der DAB-Betrieb und/oder der DAT-Betrieb und/oder der Navigationssprachausgabebetrieb und/oder der Video-/TV-Betrieb und/oder der Multimediabetrieb und/oder der Verkehrsfunkbereitschaftsbetrieb ist und der Hintergrundsuchlauf periodisch erfolgt.

5. Rundfunkempfänger nach einem der Ansprüche 1 bis 4,
**dadurch gekennzeichnet,**
daß der Mikrocomputer beim Vorliegen eines Unterbrechungssignals den Hintergrundsuchlauf unterbricht und nach der Unterbrechung mit der Frequenz fortsetzt, bei der der Hintergrundsuchlauf unterbrochen wurde.

6. Rundfunkempfänger nach einem der Ansprüche 1 bis 5,
**dadurch gekennzeichnet,**
daß die Informationen über die Empfangsqualität eine Feldstärkeinformation enthalten und/oder daß die Informationen über die Empfangsfeldstärke eine Information über das Vorliegen von Mehrwegeempfang und/oder eine Information über die Mittigkeit des Senders enthalten.

7. Rundfunkempfänger nach einem der Ansprüche 1 bis 6,
**dadurch gekennzeichnet,**
daß der Senderspeicher (5) einen ersten Speicherblock zur Abspeicherung der Empfangsdaten von FM-Sendern, einen zweiten Speicherblock zur Abspeicherung der Empfangsdaten von FM-RDS-Sendern und einen dritten Speicherblock zur Abspeicherung der Empfangsdaten von weiteren Rundfunksendern aufweist und/oder daß die im ersten Speicherblock des Senderspeichers abgespeicherten Empfangsdaten bezüglich aufsteigender oder abfallender Empfangsfrequenzen sortiert sind.

8. Rundfunkempfänger nach Anspruch 7,
**dadurch gekennzeichnet,**
daß die im zweiten Speicherblock des Senderspeicher abgespeicherten Empfangsdaten in Abhängigkeit von den PI-Codes sortiert werden.

9. Rundfunkempfänger nach einem der Ansprüche 7 bis 8,
**dadurch gekennzeichnet,**
daß die im zweiten Speicherblock des Senderspeichers abgespeicherten Empfangsdaten eines Rundfunkprogramms den PI-Code des Rundfunkprogramms enthalten und/oder daß die im zweiten Speicherblock des Senderspeichers abgespeicherten Empfangsdaten eines Rundfunkprogramms die TP-Kennung und/oder die PTY-Kennung und/oder alternative Frequenzen des Rundfunkprogramms enthalten.

10. Rundfunkempfänger nach einem der Ansprüche 1 bis 9,
**dadurch gekennzeichnet,**
daß die im Senderspeicher abgespeicherten Empfangsdaten eines Rundfunkprogramms jeweils eine Prioritätsinformation enthalten und/oder daß die Empfangsdaten mit der niedrigsten Prioritätsinformation bei gefülltem Senderspeicher und bei Auffinden eines weiteren Rundfunkprogrammes mit höherer Prioritätsinformation im Senderspeicher überschrieben werden.

11. Rundfunkempfänger nach einem der Ansprüche 1 bis 10,
**dadurch gekennzeichnet,**
daß zur Beurteilung der Empfangsqualität ein Feldstärkeschwellwert verwendet wird, bei dessen Überschreiten das Vorliegen eines Rundfunkprogrammes hinreichender Empfangsqualität detektiert wird und/oder daß der Feldstärkeschwellwert werksseitig vorgegeben ist und/oder daß der Feldstärkeschwellwert durch Auswertung der Empfangsfeldstärken der empfangenen Signale automatisch an die vorliegenden Empfangsbedingungen angepaßt wirdund/oder daß die vorliegenden Empfangsbedingungen durch eine Mittelung von Empfangfeldstärken ermittelt werden und/oder daß werksseitig mehrere Feldstärkeschwellwerte vorgegeben sind, von denen einer ausgewählt wird.
